Europäisches Patentamt

European Patent Office

Office européen des brevets

(19)

(11) Veröffentlichungsnummer: **0 221 201**
**A1**

(12) **EUROPÄISCHE PATENTANMELDUNG**

(21) Anmeldenummer: 85114260.4

(22) Anmeldetag: 08.11.85

(51) Int. Cl.⁴: **H05K 5/03**

(43) Veröffentlichungstag der Anmeldung:
**13.05.87 Patentblatt 87/20**

(84) Benannte Vertragsstaaten:
**CH DE FR GB IT LI NL**

(71) Anmelder: **C.A. Weidmüller GmbH & Co.**
**Postfach 950 Paderborner Strasse 175**
**D-4930 Detmold 14(DE)**

(72) Erfinder: **Conrad, Horst**
**Dissestrasse 20**
**D-4930 Detmold(DE)**
Erfinder: **Tobergte, Konrad**
**Robert Koch Strasse 28**
**D-4930 Detmold(DE)**
Erfinder: **Schulze, Rainer**
**Schmaler Weg 7**
**D-4930 Detmold(DE)**

(74) Vertreter: **Loesenbeck, Karl-Otto, Dipl.-Ing. et al**
**Jöllenbecker Strasse 164**
**D-4800 Bielefeld 1(DE)**

(54) **Einbaugehäuse für elektrische und elektronische Schaltungen.**

(57) Bei diesem Einbaugehäuse für elektrische und elektronische Schaltungen und Bausteine, bestehend aus einem die Schaltungen bildenden Rahmen (1), mit dem seitliche Abschlußplatten (8) verrastbar sind, weist die Schmaloberseite des Rahmens (1) verschiedene Durchbrechungen (4, 5) für unterschiedliche Anschlußtechniken, insbesondere auch für aus dem Gehäuse vorstehende fahnenförmige Anschlußstücke (7) auf. Für diese ist ein mit schmalen Durchbrechungen versehenes Berührungsschutzgehäuseteil (9, 10) aus Isolierstoff vorgesehen, das an den seitlichen Abschlußplatten (8) gehalten ist.

Fig. 1

Die Erfindung betrifft ein Einbaugehäuse für elektrische und elektronische Schaltungen und Bausteine, bestehend aus einem die Gehäuseschmalseiten bildenden Rahmen mit mehreren unterschiedlichen Durchbrechungen, auch auf seiner Schmaloberseite, sowie mit seitlichen, mit dem Rahmen verrastbaren Abschlußplatten.

Derartige bekannte Einbaugehäuse, die häufig auf der unteren Schmalseite noch mit einem Rastfuß verbunden sind oder verbindbar sind, so daß sie in Anreihungen auf genormten Tragschienen aufgerastet werden können, sind in verschiedenen Ausführungen bekannt, und zwar auch in solchen, bei denen in dem Rahmen auf dessen Schmaloberseite unterschiedliche Durchbrechungen für die wahlweisen unterschiedlichen Anschlußtechniken für die Bausteine und elektrischen Schaltungen, die im Einbaugehäuse angeordnet werden sollon, vorgesehen sind. Insbesondere handelt es sich dabei einerseits um kreisförmige Löcher, die den Zugang zu den Klemmschrauben von Zugbügelanschlüssen im Inneren des Einbaugehäuses ermöglichen, sowie ferner um Durchtrittsschlitze für fahnenförmige Anschlußteile, insbesondere Flachsteckerfahnen, oder aber auch Lötfahnen, die hier dann aus dem Einbaugehäuse oberseitig vorstehen, Es kann ferner auch noch eine Durchbrechung vor den Durchtritt eines beispielsweise mit einer Leiterplatte im Inneren des Einbaugehäuses verbundenen elektronischen Bausteines vorgesehen sein.

Mit dem zunehmenden Einsatzbereich derartiger Einbaugehäuse, auch bezüglich des Spannungsbereiches der elektrischen und elektronischen Bausteine, stellt sich das Problem eines Berührungsschutzes für die blank aus der Schmaloberseite der Einbaugehäuse vorstehenden fahnenförmigen Anschlüsse.

Der vorliegenden Erfindung liegt von daher die Aufgabe zugrunde, ein Einbaugehäuse der gattungsgemäßen Art zu schaffen, das unter Beibehaltung der Flexibilität seines Einsatzbereiches bezüglich unterschiedlicher Anschlußtechniken unter Berücksichtigung einer möglichst einfachen Herstellungsweise einen zuverlässigen Berührungsschutz gewährleistet.

Die erfindungsgemäße Lösung besteht darin, daß ein mit schmalen Durchbrechungen versehenes Berührungsschutzgehäuseteil aus Isolierstoff vorgesehen ist, das zumindest über einem Teilbereich der Schmaloberseite des Rahmens des Einbaugehäuses einen berührungsgeschützten Aufnahmeraum bildet und das an den seitlichen Abschlußplatten gehalten ist.

In dem auf diese Weise gebildeten Aufnahmeraum über zumindest einem Teilbreich der Schmaloberseite des Rahmens des Einbaugehäuses erhalten durch dieses zusätzliche Berührungsschutzgehäuseteil aus Isolierstoff etwaig dort entsprechend des Verwendungszweckes und der Anschlußtechnik vorstehende fahnenförmige Anschlüsse einen Berührungsschutz, wobei die Verdrahtung dieser Anschlüsse problemlos durch die schmalen Durchbrechungen in diesem Berührungsschutzgehäuseteil hindurchtreten können.

In weiterer Ausgestaltung dieser Anordnung besteht einerseits die Möglichkeit, das Berührungsschutzgehäuseteil mit den seitlichen Abschlußplatten des Einbaugehäuses mittels einer Verrastung zu verbinden. In diesen Fall ist somit das Berührungsschutzgehäuseteil ein eigenständiges Zusatzelement. Sowohl der Rahmen wie die seitlichen Abschlußplatten des Einbaugehäuses selbst behalten einheitlich immer die gleiche Ausführungsform und es werden dann nur zweckmäßig an die jeweilige Anwendung angepaßte unterschiedliche Zusatzteile vorgesehen, beispielsweise solche, die sich nur über einen Teil der Schmaloberseite des Rahmens erstrecken, um in einem entsprechenden Anwendungsfall nur dort austretende fahnenförmige Anschlußstücke zu schützen, sowie ferner auch Zusatzteile, die sich über die gesamte obere Schmalseite des Rahmens erstrecken, wenn in entsprechender Verteilung oberseitig vorstehende fahnenförmige Anschlüsse vorhanden sind. Letztere Ausführungsform hat den Vorteil, daß zusätzlich auch ein guter Objektschutz für gegebenenfalls aus der Schmaloberseite des Einbaugehäuses vorstehende elektronische Bausteine gewährleistet ist. Insgesamt bleibt die Herstellung des Systemes in seiner Gesamtheit sehr einfach, da lediglich bei einheitlichem Rahmen und einheitlichen Abschlußplatten unterschiedliche, hinzufügbare Zusatzteile herzustellen und zu bevorraten sind.

Es ist andererseits auch ohne weiteres möglich, das Berührungsschutzgehäuseteil geteilt auszubilden und die beiden Teilstücke jeweils an eine seitliche Abschlußplatte anzuformen, wobei zweckmäßig dann auch die beiden Teilstücke des Berührungsschutzgehäuseteiles miteinander verrastbar sind. Auch hier bleibt die Herstellung des Gesamtsystemes einfach, da ein einheitlicher Rahmen eingesetzt werden kann und lediglich 2 -3 unterschiedliche Arten von Abschlußplatten herzustellen und zu bevorraten sind, nämlich solche ohne angeformte Teilstücke für den Berührungsschutz sowie solche mit angeformten Teilstücken, letztere gegebenenfalls wieder in der oben genannten Unterteilung mit Erstreckung des Berührungsschutzes nur über einen Teil der Schmalseitenoberfläche des Rahmens oder über dessen ganze Erstreckung.

Ausführungsbeispiele der erfindungsgemäßen Einbaugehäuse werden nachstehend unter Bezugnahme auf die Zeichnung beschrieben.
Es zeigen

Figur 1 ein Einbaugehäuse gemäß der Erfindung, bei dem das Berührungsschutzgehäuseteil ein gesondertes, anrastbares Zusatzteil ist, in Perspektive mit sprengbildlicher Darstellung,

Figur 2 eine Seitenansicht eines weiteren Einbaugehäuses gemäß der Erfindung unter Fortlassung der einen, seitlichen Abstützplatte mit daran angeformtem Berührungsschutzgehäuseteil,

Figur 3 ein weiteres Einbaugehäuse gemäß der Erfindung in Seitenansicht, ebenfalls unter Fortlassung einer seitlichen Abstützplatte mit daran angeformtem Berührungsschutzgehäuseteil,

Figur 4 eine Draufsicht auf das Einbaugehäuse nach Figur 3, komplett mit beiden seitlichen Abstützplatten.

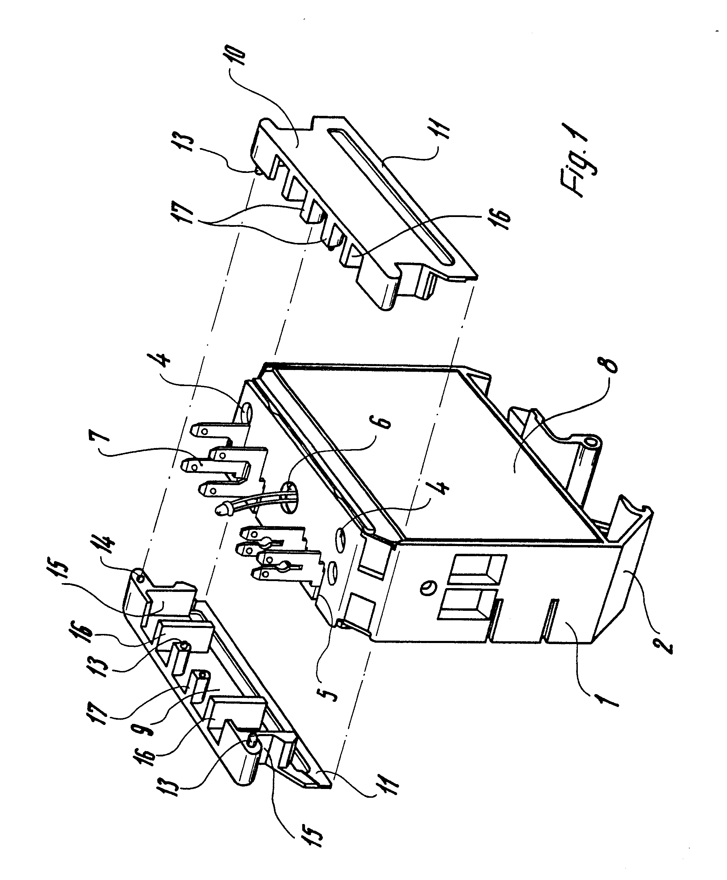

Das in Figur 1 dargestellte Einbaugehäuse für elektrische und elektronische Schaltungen und Bausteine hat einen die Gehäuseschmalseiten bildenden Rahmen 1, der unterseitig mit einem Rastfuß 2 zur Aufrastung des Einbaugehäuses auf einer genormten Tragschiene versehen ist. In dem Rahmen 1 sind funktionsgerecht diverse unterschiedliche Durchbrechungen zum Ein-und Ausführen von Leitern, Anschlußteilen und dergleichen vorgesehen, wobei hier insbesondere die Durchbrechungen in der Schmaloberseite des Rahmens 1 von Interesse sind. Hier ist er, um an die verschiedensten Anschlußtechniken anpaßbar zu sein, sowohl vorne wie hinten jeweils einerseits mit Durchbrechungen in Form von Löchern 4 sowie mit seitlichen Durchtrittsschlitzen 5 versehen und hat in seiner Mitte eine weitere Durchbrechung in Form eines Loches 6. Die Löcher 4 dienen dem Zugang von im betroffenen Innenbereich des Einbaugehäuses angeordneten Klemmschrauben von Zugbügelanschlüssen. Durch die Schlitze 5 werden gegebenenfalls fahnenförmige Anschlüsse 7 aus dem Einbaugehäuse herausgeführt, beispielsweise Flachsteckanschlüsse. Aus dem Loch 6 können bei bestimmten Anwendungsfällen elektronische Bauelemente vorstehen, die im Inneren des Einbaugehäuses beispielsweise mit einer elektrischen Leiterplatte verbunden sind.

Die beiden Seitenflächen des Einbaugehäuses 1 werden in bekannter Weise mittels seitlicher Abschlußplatten 8 verschlossen, die Rastelemente tragen, die mit entsprechenden Raststücken am Rahmen 1 zusammenwirken.

Wird ein derartiges Einbaugehäuse nur im Zusammenhang mit der Zugbügelanschlußtechnik benutzt, bestehen keine Berührungsschutzprobleme. Werden jedoch auf der einen Seite oder gar auf beiden Seiten die fahnenförmigen Anschlußstücke 7 benötigt, die dann aus der Schmaloberseite des Rahmens 1 vorstehen, bietet ein derartiges Einbaugehäuse zunächst keinen Berührungsschutz hierfür.

Erfindungsgemäß ist nun ein zusätzliches Berührungsschutzgehäuseteil aus Isolierstoff vorgesehen, wobei im Ausführungsbeispiel nach Figur 1 dieses Berührungsschutzgehäuseteil ein eigenständiges Zusatzteil ist, das im Bedarfsfall mit den seitlichen Abschlußplatten 8 verbunden wird. Im Ausführungsbeispiel nach Figur 1 ist das Berührungsschutzgehäuseteil selbst geteilt ausgebildet und besteht aus den beiden Teilstücken 9 und 10, die jeweils unterseitig mit einem ausgesparten, in gewissen Grenzen verformbaren Rastbügel 11 versehen sind, wobei an den seitlichen Abschlußplatten 8 in deren oberen Bereich eine den Rastbügel 11 aufnehmende Rastnut 12 eingeformt ist.

Die beiden Teilstücke 9 und 10 des Berührungsschutzgehäuseteiles sind auf den einander zugewandten Seiten jeweils mit mehreren Rastzapfen 13 bzw. entsprechenden Rastlöchern 14 versehen, so daß die beiden Teilstücke auch untereinander noch fest miteinander verrastet werden können. Die beiden Berührungsschutzgehäuseteile sind vorne und hinten mit Abschlußstücken 15 und verschiedenen Stegen 16 und 17 versehen, die so abständig voneinander angeordnet sind, daß sie nach Zusammenfügen der Teilstücke 9 und 10 jeweils zwischen sich schmale Durchbrechungen bilden, durch die Leiter, Kabel und dergleichen problemlos nach oben außen austreten können, während andererseits für die blanken Anschlüsse 7 zuverlässiger Berührungsschutz gegeben ist. Diese liegen im Inneren des Berührungsschutzgehäuseteiles 9, 10. Wie die Anschauung zeigt, kann durch entsprechend wenig weit nach unten reichende Stege 17 im mittleren Bereich des Berührungsschutzgehäuseteiles 9, 10 ein relativ großer Aufnahmeraum geschaffen werden, in dem dann gegebenenfalls ein aus der Schmaloberseite des Einbaugehäuses vorstehendes elektronisches Bauelement objektgeschützt liegt.

Bei dieser Ansgestaltung kommt für die diversen Anwendungsfälle immer nur ein und dasselbe Einbaugehäuse bestehend aus dem Rahmen 1 und den seitlichen Abschlußplatten 8 zum Einsatz, während bezüglich des Berührungsschutzgehäuseteiles unterschiedliche Ausführungsformen bevorratet werden können. Zum einen kann dies ein Berührungsschutzgehäuseteil 9, 10 wie vorstehend beschrieben und in Figur 1 gezeigt sein. Es kann hier jedoch auch eine verkürzte Ausführungsform vorgesehen werden, bei der sich das Berührungsschutzgehäuseteil bei grundsätzlich gleichem Aufbau nur über die halbe Tiefe des Einbaugehäuses erstreckt, was dann interessant ist, wenn in einem Anwendungsfall auf der einen Seite mit der Zugbügelanschlußtechnik gearbeitet wird und nur auf der anderen Seite mit vorstehenden fahnenförmigen Anschlüssen 7 gearbeitet wird.

Abweichend vom dargestellten Ausführungsbeispiel eines geteilten Berührungsschutzgehäuseteiles kann dieses auch insgesamt einstückig ausgebildet sein, da auch dann ohne weiteres die Rastbügel 11 unten an einem einstückigen Gehäuseteil flexibel genug sind, um eine einwandfreie Montage an den seitlichen Abschlußplatten 8 zu gewährleisten.

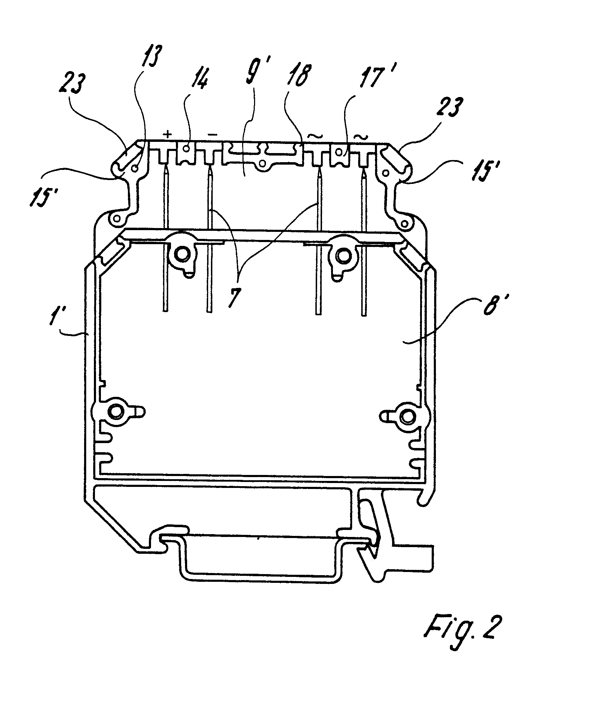

Bei dem in Figur 2 dargestellten Ausführungsbeispiel eines erfindungsgemäßen Einbaugehäuses ist das geteilt ausgebildete Berührungsschutzgehäuseteil dadurch gebildet, daß entsprechende Teilstücke, wie beispielsweise das in Figur 2 dargestellte Teilstück 9', direkt jeweils an die betreffende seitliche Abschlußplatte 8' angeformt sind. Werden die Seitenplatten 8' dann in der üblichen Weise mit dem Rahmen 1' des Einbaugehäuses rastend zusammengefügt, fügen sich dabei automatisch auch die beiden Teilstücke zu dem Berührungsschutzgehäuseteil über der Schmaloberseite des Rahmens 1' zusammen.

Um dem Berührungsschutzgehäuseteil auch insoweit einen sicheren Zusammenhalt zu geben, werden zweckmäßigerweise auch die Teilstücke miteinander verrastet, wozu gemäß Figur 2 beispielsweise das Teilstück 9' wieder teils mit Rastzapfen 13, teils mit Rastlöchern 14 versehen ist. Beim Ausführungsbeispiel nach Figur 2 erstreckt sich das Berührungsschutzgehäuseteil im wesentlichen über die ganze Tiefe des Einbaugehäuses. Es sind wiederum durch mehr oder weniger große, voneinander abständige Stege 17' und 18 sowie vordere und hintere Wandstücke 15' Durchbrechungen in der Oberseite des Berührungsschutgehäuses gebildet, durch die Leiter, Kabel und dergleichen hindurchtreten können. Die Anschauung der Figur 2 zeigt dabei die berührungsgeschützte Lage der aus der Schmaloberseite des Rahmens 1' hervorstehenden fahnenförmigen Anschlüsse 7.

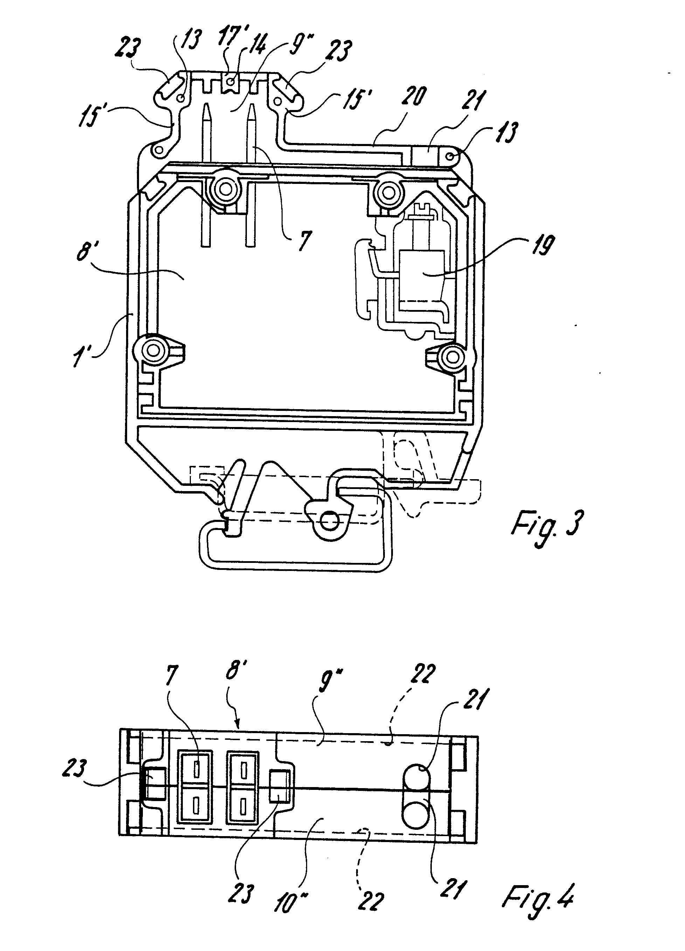

Nach den Figuren 3 und 4 ist das Berührungsschutzgehäuseteil geteilt ausgebildet und die beiden Teilstücke sind jeweils an eine seitliche Abschlußplatte 8' angeformt. Im Gegensatz zum Ausführungsbeispiel nach Figur 2 erstreckt sich hier das eigentliche Berührungsschutzgehäuseteil nur über einen Teil der Tiefe des Einbaugehäuses. Es handelt sich hier somit um einen Anwendungsfall, bei dem nur im vorderen oder im hinteren Bereich des Einbaugehäuses Schaltungen oder Bausteine vorgesehen sind, die mit vorstehenden fahnenförmigen Anschlüssen 7 versehen sind, während im anderen Bereich des Einbaugehäuses Bausteine vorgesehen sind, die mit der Zugbügeltechnik arbeiten, wobei in Figur 3 durch Fortlassung der einen seitlichen Abschlußplatte beispielsweise ein derartiges Zugbügelelement 19 sichtbar ist.

Die beiden Teilstücke 9" und 10" (siehe Figur 4), die nach der Verrastung der seitlichen Abschlußplatten 8' am Rahmen 1' das Gehäuse bilden und die zweckmäßig wiederum untereinander durch Rastelemente 13, 14 verrastbar sind, haben wieder vorne und hinten Wandstücke 15', die zusammen mit einem Steg 17' wieder die schmalen Durchbrechungen definieren, durch die hindurch Kabel oder Leiter zu den Anschlußstücken 7 geführt werden können, wie insbesondere aus Figur 4 ersichtlich.

Aus Gründen der Stabilität ist zweckmäßig hier an die seitlichen Abschlußplatten 8' oben neben dem eigentlichen Berührungsschutzgehäuseteil 9" bzw. 10" noch ein über den Rest der Tiefe des Einbaugehäuses verlaufendes Ansatzstück 20 angeformt, das an seinem dem Berührungsschutzgehäuseteil abgewandten Ende nochmals eine Verrastungsmöglichkeit bietet und das dann eine Durchlaßöffnung 21 dort hat, wo in der Schmaloberseite des Rahmens 1' die Durchtrittslöcher 4 für den Schraubendreher vorgesehen sind, so daß trotz dieses Ansatzstückes hier die Klemmschrauben der Zugbügelelemente 19 von oben zugänglich bleiben.

Bei den Ausführungsbeispielen nach den Figuren 2, 3 und 4 ist ferne vorgesehen, daß die seitlichen Kanten 22 (siehe Figur 4) der Schmaloberseite des Rahmens 1' um die Dicke der Abschlußplatten 8' gegenüber der Rahmenbreite im übrigen zurückspringen, so daß hier die seitlichen Abschlußplatten 8' durchgängig glattwandig über die Schmaloberseite des Rahmens 1' hochgeführt werden können, so daß eine glattwandige Anreihbarkeit dieser Anbaugehäuse auf der genormten Tragschiene, ohne eine Verbreiterung der Einbaugehäuse in Anreihrichtung gesehen gewährleistet ist.

In weiterer zweckmäßiger Ausgestaltung (siehe Figuren 2, 3 und 4) können die Berührungsschutzgehäuseteile 9', 9", 10' insbesondere in den oberen Eckbereichen ihrer Wandstücke 15' noch mit zusätzlichen Aufnahmen 23 für Bezeichnungsträger versehen sein, so daß in vorteilhafter Weise auch diese Berührungsschutzgehäuseteile noch mit als Kennzeichnungsträger verwendet werden können.

**Ansprüche**

1. Einbaugehäuse für elektrische und elektronische Schaltungen und Bausteine, bestehend aus einem die Gehäuseschmalseiten bildenden Rahmen mit mehreren unterschiedlichen Durchbrechungen auch auf der Schmaloberseite, sowie mit seitlichen, mit dem Rahmen verrastbaren Abschlußplatten, **gekennzeichnet durch** ein mit schmalen Durchbrechungen versehenes Berührungsschutzgehäuseteil (9, 10, 9', 9", 10") aus Isolierstoff, das zumindest über einem Teilbreich der Schmaloberseite des Rahmens (1, 1') einen berührungsgeschützten Aufnahmeraum bildet und das an den seitlichen Abschlußplatten (8, 8') gehalten ist.

2. Einbaugehäuse nach Anspruch 1, dadurch gekennzeichnet, daß das Berührungsschutzgehäuseteil (9', 9", 10") geteilt ausgebildet und die beiden Teilstücke jeweils an eine Abschlußplatte (8') angeformt und miteinander verrastbar sind.

3. Einbaugehäuse nach Anspruch 1, dadurch gekennzeichnet, daß das Berührungsschutzgehäuseteil (9, 10) mit den Abschlußplatten (8) mittels einer Verrastung (11, 12) verbindbar ist.

4. Einbaugehäuse nach Anspruch 3, dadurch gekennzeichnet, daß das Berührungsschutzgehäuseteil aus zwei miteinander verrastbaren Teilstücken (9, 10) gebildet ist.

5. Einbaugehäuse nach einem oder mehreren der vorhergehenden Ansprüche, dadurch gekennzeichnet, daß sich das Berührungsschutzgehäuseteil (9, 10; 9') über die gesamte Tiefe der Schmaloberseite des Rahmens (1, 1') erstreckt.

6. Einbaugehäuse nach einem oder mehreren der vorhergehenden Ansprüche, dadurch gekennzeichnet, daß die schmalen Durchbrechungen im Berührungsschutzgehäuseteil (9, 10, 9', 9", 10") durch von einander abständige oberseitige Stege (16, 17, 17') und vordere und hintere Wandstücke (15, 15') gebildet sind.

7. Einbaugehäuse nach einem oder mehreren der vorhergehenden Ansprüche, dadurch gekennzeichnet, daß in dem Berührungsschutzgehäuseteil (9, 10, 9', 9", 10") Bezeichnungsträgeraufnahmen (23) vorgesehen sind.

8. Einbaugehäuse nach einem oder mehreren der vorhergehenden Ansprüche, dadurch gekennzeichnet, daß bei sich über die ganze Tiefe der Schmaloberseite des Rahmens (1, 1') erstreckendem Berührungsschutzgehäuseteil (9, 10, 9') zumindest im mittleren Bereich des Berührungsschutzgehäuseteiles Stege (17, 18) vorgesehen sind, die sich von oben nur ein kurzes Stück in Richtung auf die Schmaloberseite des Rahmens (1, 1') erstrecken.

9. Einbaugehäuse nach Anspruch 3, dadurch gekennzeichnet, daß an den seitlichen Unterkanten der Berührungsschutzgehäuseteile (9, 10) Rastbügel (11) angeformt sind, für die im oberen Bereich der seitlichen Abschlußplatten (8) Aufnahmenuten (12) vorgesehen sind.

10. Einbaugehäuse nach Anspruch 2, dadurch gekennzeichnet, daß die Seitenkanten (22) der Schmaloberseite des Rahmens (1') um die Dicke der seitlichen Abschlußplatte (8') gegenüber dem Rahmen im übrigen zurückspringen.

11. Einbaugehäuse nach Anspruch 1 oder 2, dadurch gekennzeichnet, daß bei einem sich nur über einen Teil der Tiefe des Einbaugehäuses erstreckendem Berührungsschutzgehäuseteil (9", 10") ein sich über die restliche Tiefe erstreckendes Ansatzstück angeformt ist, das sich flach über die Schmaloberseite des Rahmens (1') erstreckt und einen Durchlaß (21) für Schraubendreher definiert.

Fig. 1

0 221 201

Fig. 2

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | DE-U-7 618 851 (KATHREIN)<br>* Figuren 1-5; Ansprüche 1-3 * | 1-6,8 | H 05 K 5/03 |
| X | DE-A-2 454 154 (DOLD)<br><br>* Figuren 1, 2; Seite 2, Zeile 12 - Seite 3, Zeile 10 * | 1,3,5,6,9,11 | |
| A | GB-A-1 482 787 (CIT-ALCATEL)<br><br>* Figuren 1A-5; Seite 1, Zeile 68 - Seite 2, Zeile 130 * | 1,3,5,9,11 | |

RECHERCHIERTE
SACHGEBIETE (Int. Cl.4)

H 05 K 5/00
H 05 K 5/03

Der vorliegende Recherchenbericht wurde für alle Patentansprüche erstellt.

| Recherchenort<br>BERLIN | Abschlußdatum der Recherche<br>10-06-1986 | Prüfer<br>HAHN G |
|---|---|---|